# EUROPÄISCHE PATENTSCHRIFT

(11) **EP 2 701 288 B1**
(45) Veröffentlichungstag und Bekanntmachung des Hinweises auf die Patenterteilung: **21.04.2021**
(21) Anmeldenummer: 13004090.0
(22) Anmeldetag: 17.08.2013
(51) Int. Cl.: H02K 11/00, H02K 29/08, H05K 1/02

(54) **Platine zur Verwendung in einer elektrischen Maschine, insbesondere in einem Elektromotor, vorzugweise einem Außenläufermotor, sowie drehende elektrische Maschine mit einer solchen Platine**
Printed circuit board for use in an electric machine, in particular an electric motor, preferably an outer rotor motor, and rotating electric machine with such a printed circuit board
Platine destinée à une machine électrique, notamment moteur électrique, préférablement un moteur à rotor extérieur, et machine électrique rotative comprenant une telle platine

(30) Priorität: 22.08.2012 DE 102012016912
(43) Veröffentlichungstag der Anmeldung: 26.02.2014
(73) Patentinhaber: ZIEHL-ABEGG SE, 74653 Künzelsau (DE)
(72) Erfinder: Sturm, Thorsten, 74238 Krautheim (DE); Korn, Bernd, 74673 Mulfingen (DE); Schad, Jürgen, 74635 Kupferzell (DE); Sahm, Marco, 74653 Ingelfingen (DE)
(74) Vertreter: Kohl, Karl-Heinz

(56) Entgegenhaltungen:
- EP-A2- 0 886 462
- WO-A1-01/80407
- WO-A2-00/57541
- US-A- 4 604 665
- US-A1- 2010 270 923

## Beschreibung

Die Erfindung betrifft eine Platine zur Verwendung in einer elektrischen Maschine, insbesondere in einem Elektromotor, vorzugsweise einem Außenläufermotor, nach dem Oberbegriff des Anspruches 1 sowie eine drehende elektrische Maschine mit einer solchen Platine nach Anspruch 11.

Bei Elektromotoren ist es bekannt, beispielsweise elektrische/elektronische Komponenten in Form von Lagegebern einzusetzen, die auf Platinen angeordnet sind und mit denen die Lage, die Drehzahl und/oder die Drehrichtung eines Rotors erfasst werden können. Die Lagegeber müssen hierzu im Magnetfeld des Rotors positioniert werden. Die Signale der Lagegeber werden über die Platine und den elektrischen Anschluss an eine Leistungselektronik übertragen. Aufgrund der Motorwicklung ist für den Einbau der Platine nur ein sehr beengter Bauraum vorhanden. Häufig müssen noch weitere elektrische/elektronische Komponenten auf der Platine vorgesehen werden, beispielsweise Temperatursensoren. Die Lagegeber sowie diese zusätzlichen Komponenten werden konventionell bedrahtet und an die Platine angelötet. Die unterschiedlichen Lötseiten der Platine führen zu erheblichen Kosten für die Herstellung der Platine. Auch die Handbestückung der Komponenten schlägt sich im Preis nieder. Zudem bereitet es Schwierigkeiten, die Platine dort einzusetzen, wo nur geringer Bauraum zur Verfügung steht.

Der Erfindung liegt die Aufgabe zugrunde, die gattungsgemäße Platine sowie die gattungsgemäße drehende elektrische Maschine so auszubilden, dass eine kostengünstige und einfache Herstellung und Montage gewährleistet ist, wobei die Platine auch in engen Einbauräumen untergebracht werden kann.

Diese Aufgabe wird bei der gattungsgemäßen Platine erfindungsgemäß mit den kennzeichnenden Merkmalen des Anspruches 1 und bei der drehenden elektrischen Maschine erfindungsgemäß mit den Merkmalen des Anspruches 11 gelöst.

Der Platinenkörper der erfindungsgemäßen Platine hat wenigstens zwei gegeneinander bewegliche formstabile Segmente, die über wenigstens eine Biegestelle miteinander verbunden sind. Sie wird durch eine Querschnittsverjüngung des Platinenkörpers gebildet, die herstellungstechnisch einfach am Platinenkörper vorgesehen werden kann, beispielsweise durch einen Fräs- oder Ritz- bzw. Schneidvorgang. Die Platine lässt sich somit sehr kostengünstig fertigen. Aufgrund der Biegestelle ist es möglich, die an der Platine vorgesehene elektrische/elektronische Komponente durch entsprechendes Biegen des Platinenkörpers in die für den Einbau günstigste Lage zu bringen. Aufgrund der gegeneinander bewegbaren Segmente lässt sich die erfindungsgemäße Platine sehr kompakt ausbilden. Das mit der elektrischen/elektronischen Komponente versehene Segment wird so gegenüber dem anderen Segment beim Einbau bewegt, dass die Komponente in die gewünschte Einbauposition gelangt. Da die Segmente formstabil ausgebildet sind, ist die Montage der Platine mit der auf ihr befindlichen elektrischen/elektronischen Komponente einfach und zuverlässig möglich.

Die elektrische/elektronische Komponente ist vorteilhaft ein SMD-Bauteil. Dadurch ist es möglich, die Platine automatisiert zu fertigen. Dies trägt, insbesondere in Verbindung mit der kompakten Bauweise, zu einer erheblichen Kosteneinsparung bei.

Die elektrische/elektronische Komponente ist vorteilhaft ein Sensor.

Die elektrisch/elektronische Komponente ist vorteilhaft ein Lagegeber, mit dem die Drehlage, die Drehzahl und/oder die Drehrichtung eines drehenden Bauteiles des Elektromotors erfasst werden kann.

Die elektrisch/elektronische Komponente kann beispielsweise auch ein Temperatursensor sein, mit dem die Wicklungstemperatur oder die Motortemperatur des Elektromotors erfasst werden kann. Der Sensor, wie der Lagegeber oder der Temperatursensor, sind vorteilhaft SMD-Bauteile, so dass durch den Einsatz solcher SMD-Bauteile eine automatisierte Fertigung der erfindungsgemäßen Platine möglich ist.

Der Anschluss der Platine kann durch Kontaktstifte oder durch Kontaktflächen auf der Platine gebildet sein.

Werden Kontaktstifte eingesetzt, werden sie vorteilhaft durch eine Leiste zusammengehalten. Da die Segmente formstabil ausgebildet sind, lässt sich der Anschluss sicher an dem entsprechenden Segment befestigen bzw. anbringen.

Ein einfacher Einbau ergibt sich, wenn die Leiste und die elektrische/ elektronische Komponente an der gleichen Seite des Platinenkörpers vorgesehen sind.

Vorteilhaft weist die erfindungsgemäße Platine mehr als zwei gegeneinander bewegbare Segmente auf, die durch jeweils wenigstens eine Biegestelle in Form der Querschnittsverjüngung des Platinenkörpers miteinander verbunden sind. Die Biegestellen können parallel, aber auch winklig zueinander liegen. Die Segmente lassen sich einfach gegeneinander bewegen und lassen sich sehr kostengünstig und einfach am Platinenkörper anbringen.

Die Biegestellen können gleich ausgebildet sein, was zur einfachen und kostengünstigen Herstellung der Platine beiträgt.

Zumindest eines der Segmente weist erfindungsgemäss einen abstehenden Arm auf, an dem vorteilhaft die elektrische/elektronische Komponente vorgesehen ist.

Die erfindungsgemäße drehende elektrische Maschine zeichnet sich dadurch aus, dass sie mit der erfindungsgemäßen Platine ausgestattet ist. Sie kann kostengünstig hergestellt und zuverlässig auch in kleinste Bauräume eingebaut werden.

Die drehende elektrische Maschine ist vorteilhaft ein Elektromotor mit einem Stator und einem Rotor. Die Platine ist hierbei im Stator untergebracht und taucht vorteilhaft in den Rotor ein, was eine einfache Montage ermöglicht. Die Platine ist vorteilhaft hochkant im Stator angeordnet. Dadurch nimmt sie nur wenig Bauraum in Anspruch.

Die Biegestelle des Platinenkörpers verläuft vorteilhaft etwa parallel zur Achse des Stators. Dadurch können die Segmente des Platinenkörpers so um die Biegestelle gegeneinander bewegt werden, dass sich die Segmente vorteilhaft dem Durchmesser der Magnete des Rotors anpassen.

Der Anmeldungsgegenstand ergibt sich nicht nur aus dem Gegenstand der einzelnen Patentansprüche, sondern auch durch alle in den Zeichnungen und der Beschreibung offenbarten Angaben und Merkmale. Sie werden, auch wenn sie nicht Gegenstand der Ansprüche sind, als erfindungswesentlich beansprucht, soweit sie einzeln oder in Kombination gegenüber dem Stand der Technik neu sind.

Weitere Merkmale der Erfindung ergeben sich aus den weiteren Ansprüchen, der Beschreibung und der Zeichnung.

Die Erfindung wird anhand einiger in den Zeichnungen dargestellter Ausführungsbeispiele näher erläutert. Es zeigen
- Fig. 1: in schematischer Darstellung eine erfindungsgemäße Platine in Einbaulage,
- Fig. 2: ein Ausführungsbeispiel einer erfindungsgemäßen Platine,
- Fig. 3a bis Fig. 3f: unterschiedliche Ansichten einer weiteren Ausführungsform einer erfindungsgemäßen Platine,
- Fig. 4a bis Fig. 4f: in verschiedenen Ansichten eine weitere Ausführungsform einer erfindungsgemäßen Platine,
- Fig. 5a bis Fig. 5f: in verschiedenen Ansichten ein weiteres Ausführungsbeispiel einer erfindungsgemäßen Platine,
- Fig. 6: einen Axialschnitt durch einen Elektromotor mit einer erfindungsgemäßen Platine,
- Fig. 7: die Einzelheit X in Fig. 6 in vergrößerter Darstellung.

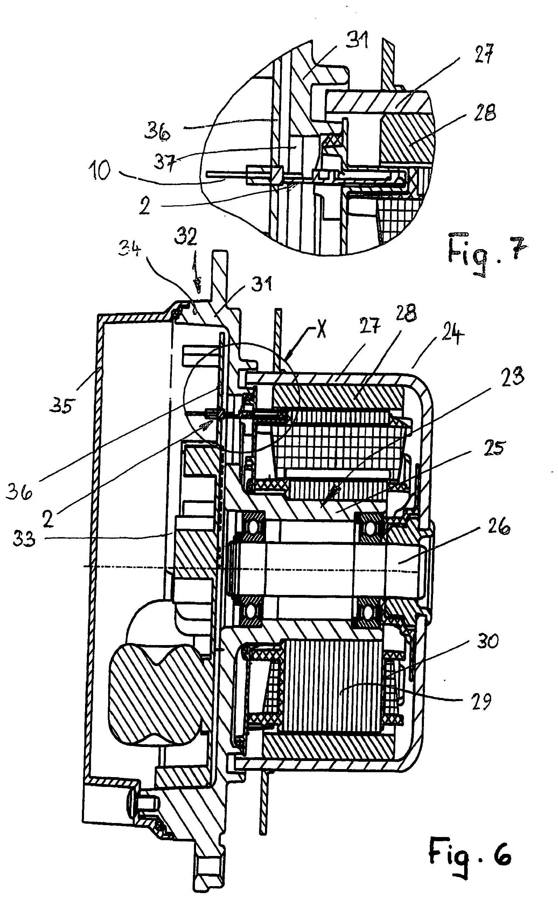

Die Platine 2 wird bei elektrischen Maschinen, bevorzugt bei Elektromotoren, eingesetzt, insbesondere bei Außenläufermotoren, die einen Stator 23 und einen Rotor 24 aufweisen (Fig. 6), die koaxial zueinander angeordnet sind. Um die Rotorlage, die Drehzahl und/oder die Drehrichtung des Rotors 24 erfassen zu können, ist die Platine 2 mit wenigstens einem Lagegeber 1, im Ausführungsbeispiel mit drei solcher Lagegeber in Form von Hall-Sensoren versehen. Die Platine 2 ist so in den Elektromotor eingebaut, dass die Lagegeber 1 im Magnetfeld des Rotors 24 liegen. Die Lagegeber 1 sind vorteilhaft SMD-Bauteile.

Der Stator 23 des Elektromotors hat eine Statorbuchse 25, in der eine Rotorwelle 26 drehbar gelagert ist. An der Innenseite des Rotormantels 27 sind in bekannter Weise Magnete 28 befestigt. Der Stator 23 hat ein Statorpaket 29, an dem eine Wicklung 30 vorgesehen ist.

Der Stator 23 hat einen radialen Statorflansch 31, der vorteilhaft einstückig mit der Statorbuchse 25 ausgebildet ist. Der Statorflansch 31 bildet den Boden eines Elektronikgehäuses 32, in dem eine Steuerelektronik sowie weitere elektrische/elektronische Komponenten 33 untergebracht sind. Auf eine Wand 34 des Elektronikgehäuses 32 wird ein haubenförmiger Abschlussdeckel 35 aufgesetzt.

Die elektrischen/elektronischen Komponenten 33 sitzen auf einer Leiterplatte 36, die im Elektronikgehäuse 32 untergebracht ist.

Die Platine 2 ist flexibel ausgebildet. Die Flexibilität wird nicht dadurch erreicht, dass die Platine 2 als Folie ausgebildet ist, sondern dadurch, dass ein Platinenkörper 3 einzelne formstabile Segmente 4 bis 6 aufweist, die gegeneinander bewegbar sind. Zwischen den Segmenten 4 bis 6 liegen Biegestellen 7, 8, die vorteilhaft parallel zueinander liegen und die ermöglichen, dass benachbarte Segmente 4 bis 6 gegeneinander begrenzt geschwenkt werden können. Die Biegestellen 7, 8 werden in vorteilhafter Weise durch Querschnittsverjüngungen des Platinenkörpers 3 gebildet. Die Biegestellen 7, 8 können in einfacher Weise beispielsweise in den Platinenkörper 3 eingefräst, eingeritzt oder eingeschnitten werden.

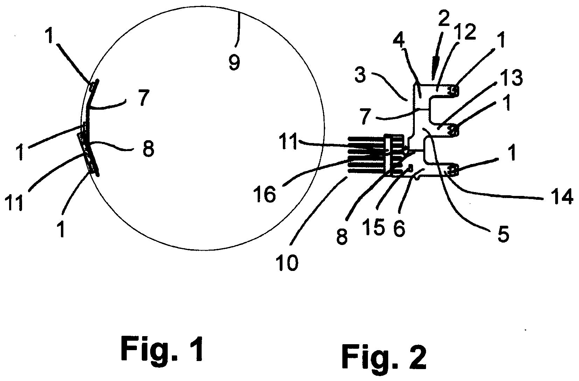

Die Platine 2 wird, wie sich aus Fig. 1 ergibt, hochkant innerhalb des Elektromotors eingebaut. In Fig. 1 ist der Durchmesser 9 der Magnete 28 des Rotors 24 des Elektromotors dargestellt. Die Flexibilität des Platinenkörpers 3 ermöglicht es, die Lagegeber 1 in unmittelbarer Nähe zum Magnetdurchmesser 9 anzuordnen. Da die Platine 2 außerdem hochkant im Stator 23 angeordnet ist, kann sie äußerst platzsparend in den Stator 23 eingebaut werden. Die Platine 2 lässt sich problemlos auch bei beengtem Bauraum einfach montieren.

Die Platine 2 hat elektrische Kontakte 10, die die elektrische Verbindung zwischen den Lagegebern 1 und einer Leistungselektronik herstellen, die sich im Elektronikgehäuse 32 des Elektromotors befindet (Fig. 6 und 7). Über die Leistungselektronik erfolgt auch die elektrische Verbindung zum Motoranschlusskabel, mit dem der Elektromotor an das Stromnetz angeschlossen wird. Die elektrischen Kontakte 10 können auch eine elektrische Verbindung zwischen den Lagegebern 1 und einem Anzeigegerät herstellen, das die von den Lagegebern 1 erfassten Kenngrößen nur anzeigt.

Die elektrischen Kontakte 10 werden durch Stifte gebildet, die an einer Leiste 11 befestigt sind.

Die Segmente 4 bis 6 sind jeweils mit einem abstehenden Arm 12 bis 14 versehen. Am freien Ende der Arme 12 bis 14 ist jeweils ein Lagegeber 1 vorgesehen. Die Arme 12 bis 14 liegen mit Abstand voneinander und sind so am jeweiligen Segment 4 bis 6 vorgesehen, dass die Arme Abstand von den Biegestellen 7, 8 haben. Dadurch können die Segmente 4 bis 6 ohne Behinderung durch die Arme 12 bis 14 in die erforderliche Einbauposition im Elektromotor gebracht werden. Beim dargestellten und beschriebenen Ausführungsbeispiel ermöglichen die abstehenden Arme 12 bis 14, dass die Lagegeber 1 ausreichend weit in die Motorwicklung 30 eingesetzt werden können, so dass eine genaue Überwachung der Rotorlage, der Drehzahl und/oder der Drehrichtung des Rotors 24 gewährleistet ist.

Bei der beispielhaften Ausführungsform trägt das Segment 6 zusätzliche Bauteile 15, die ebenfalls vorteilhaft SMD-Bauteile sind. Wenn an der Platine 2 ausschließlich SMD-Bauteile 1, 15 eingesetzt werden, ergibt sich in vorteilhafter Weise eine kompakte Bauweise und eine automatisierte Fertigung der Platine 2. Insbesondere können im Vergleich zu herkömmlichen Platinen mit konventionell bedrahteten und angelöteten Bauteilen erhebliche Kosten eingespart werden.

Die Leiste 11 liegt auf der von den Armen 12 bis 14 abgewandten Seite der Segmente 4 bis 6. Im Ausführungsbeispiel überragt das Segment 6 die beiden anderen Segmente 4, 5. An diesem überstehenden Teil ist die Leiste 11 mit den elektrischen Kontaktstiften 10 befestigt. Der überstehende Teil des Segmentes 6 ist gleich breit wie die Leiste 11, so dass diese über die Kontaktstifte 10 sicher mit dem Segment 6 verbunden werden kann. Die Leiste 11 und das Segment 6 stehen über ihre Länge über einen Teil des Segmentes 5 vor. Zwischen diesem überstehenden Segmentteil und dem benachbarten Segment 5 ist eine Aussparung 16 im Platinenkörper 3 vorgesehen. Dadurch wird die Verschwenkbarkeit des Segmentes 5 gegenüber dem Segment 6 nicht behindert. Die Biegestelle 8 liegt im Bereich dieser Aussparung 16 und verläuft quer zu ihr.

Die elektrische Verbindung zwischen den Lagegebern 1 und den elektrischen Kontaktstiften 10 erfolgt über (nicht dargestellte) Leiterbahnen im Platinenkörper 3. Auch die elektrische Verbindung zwischen dem zusätzlichen Bauteil 15 und den Kontaktstiften 10 erfolgt über Leiterbahnen.

Die Biegestellen 7, 8 sind im Bereich zwischen benachbarten Armen 12 bis 14 vorgesehen. Die Biegestellen 7, 8 erstrecken sich über die gesamte Höhe des zwischen den benachbarten Armen 12 bis 14 befindlichen Teils des Platinenkörpers 3.

Im dargestellten Ausführungsbeispiel liegen die Lagegeber 1, die Leiste 11 der Kontaktstifte 10 sowie die zusätzlichen Bauteile 15 auf der gleichen Seite des Platinenkörpers 3. Je nach Einbausituation und Anwendungsfall können die an der Platine 2 vorgesehenen Bauteile auch auf unterschiedlichen Seiten des Platinenkörpers 3 angeordnet sein.

Die einzelnen Segmente 4 bis 6 sind formstabil ausgebildet, so dass die an ihnen befestigten Bauteile 1, 11, 15 sicher befestigt und in der Einbaulage einwandfrei positioniert werden können. Die elektrische Verbindung dieser Bauteile 1, 10, 11, 15 zur Leistungselektronik ist in einfacher Weise über die Platine 2 möglich. Sie ragt durch eine Öffnung 37 im Statorflansch 31 in das Elektronikgehäuse 32 und ist an die Leiterplatte 36 angeschlossen (Fig. 7). Da die Platine 2 sehr kompakt ausgebildet ist, ist sie hervorragend für einen sehr beengten Bauraum geeignet, wie er insbesondere bei Elektromotoren im Bereich der Motorwicklung 30 üblich ist. Die Platine 2 kann automatisiert gefertigt werden, wenn in vorteilhafter Weise ausschließlich SMD-Bauteile eingesetzt werden. Die Platine 2 bildet eine Baueinheit, die sich in einem Arbeitsschritt in den Elektromotor einbauen lässt. Aufgrund der gegeneinander verschwenkbaren Segmente 4 bis 6 kann die Lage der Lagegeber 1 optimal an den Magnetdurchmesser 9 angepasst werden, wie insbesondere aus Fig. 1 hervorgeht.

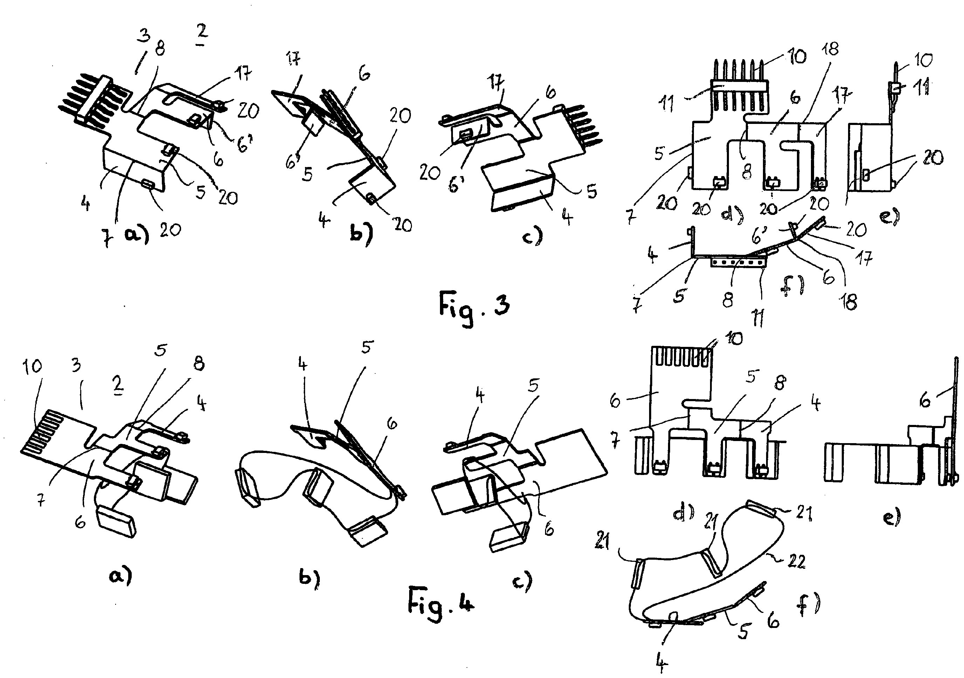

Die Fig. 3 bis 5 zeigen beispielhaft weitere Ausführungsformen von Platinen 2. Die Platine 2 gemäß Fig. 3 hat den Platinenkörper 3, der die formstabilen Segmente 4 bis 6, 6' und 17 aufweist. Am Segment 5 sind die als Stifte ausgebildeten Kontakte 10 befestigt, die an der Leiste 11 gehalten sind. Die durch die Querschnittsverjüngungen gebildeten Biegestellen 7, 8, 18 sind zwischen den Segmenten 4, 5; 5, 6 und 6, 17 vorgesehen. Diese Biegestellen erstrecken sich wiederum parallel zueinander. Die Biegestellen 8, 18 sind gleich lang und kürzer als die Biegestelle 7. An das Segment 6 ist starr ein Segment 6' rechtwinklig angeschlossen. Die einzelnen Segmente sind mit schematisch dargestellten Komponenten 20 versehen, die je nach Anwendungsfall unterschiedlich ausgestaltet sein können.

Fig. 4 zeigt beispielhaft eine Platine 2 mit einem Platinenkörper 3, der im Wesentlichen gleich ausgebildet ist wie das Ausführungsbeispiel gemäß den Fig. 1 und 2. Der Platinenkörper 3 hat die gegeneinander verschwenkbaren formstabilen Segmente 4 bis 6, die über die Biegestellen 7, 8 in Form der Querschnittsverjüngungen des Platinenkörpers 3 miteinander verbunden sind. Die elektrischen Kontakte 10 sind im Unterschied zur Ausführungsform nach den Fig. 1 und 2 nicht durch Stifte, sondern durch Kontaktflächen auf der Platine 2 gebildet. Außerdem sind Sensoren 21 über eine Leitung 22 an die Platine angeschlossen. Die Sensoren 21 können beispielhaft Temperatursensoren sein, um beispielsweise die Motor- oder Wicklungstemperatur eines Elektromotors zu überwachen.

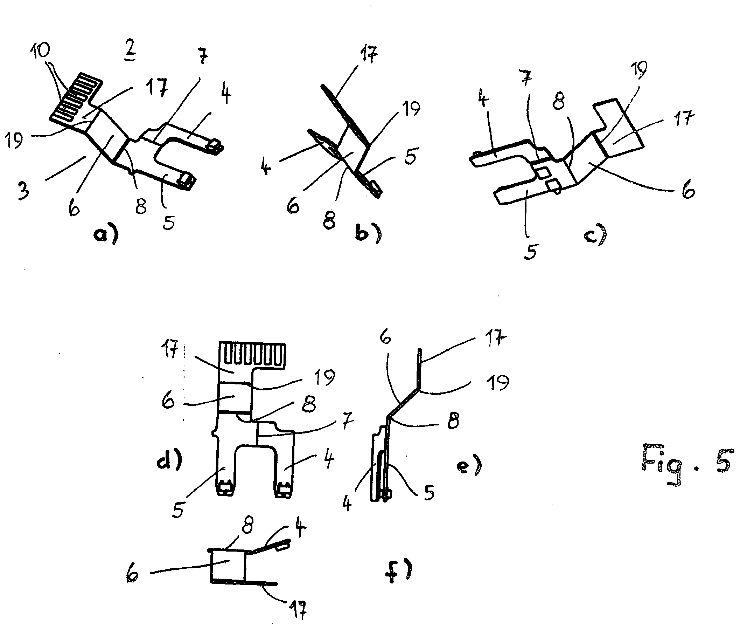

Fig. 5 zeigt eine Ausführungsform, bei der die Biegestellen nicht parallel, sondern winklig zueinander verlaufen. Die Platine 2 hat den Platinenkörper 3, der die gegeneinander verschwenkbaren formstabilen Segmente 4 bis 6, 17 aufweist. Die beiden Segmente 4, 5 sind über die Biegestelle 7 gelenkig miteinander verbunden. Die Segmente 5, 6 sind über die Biegestelle 8 und die Segmente 6, 17 über die Biegestelle 19 gelenkig miteinander verbunden. Die Biegestellen 7, 8, 19 sind jeweils durch eine Querschnittsverjüngung des Platinenkörpers 3 gebildet. Die beiden Biegestellen 8, 19 liegen bei diesem Ausführungsbeispiel parallel zueinander sowie senkrecht zur Biegestelle 7. Die elektrischen Kontakte 10 werden bei diesem Ausführungsbeispiel wiederum durch Kontaktflächen auf der Platine 2 gebildet.

Die beschriebenen Ausbildungen der Platine 2 sind nicht beschränkend zu verstehen. Wesentlich für die Platine 2 ist, dass sie aus wenigstens zwei gegeneinander verschwenkbaren formstabilen Segmenten besteht, welche die entsprechenden Bauteile tragen, wobei die Verschwenkbarkeit der Segmente durch die Querschnittsverjüngung der Platinenkörpers 3 gebildet wird. Ein solcher Platinenkörper 3 mit Querschnittsverjüngungen als Biegestellen lässt sich sehr einfach und kostengünstig fertigen. Die Platine 2 kann in unterschiedlichste Ausbildungen von Elektromotoren eingebaut werden. Aufgrund ihrer kompakten Ausbildung ist sie hervorragend für Einbausituationen geeignet, in denen nur wenig Bauraum zur Verfügung steht. Da die Platine 2 nur wenig Einbauraum benötigt, können die Elektromotoren entsprechend kompakt ausgebildet sein.

## Patentansprüche

1. Platine (2) zur Verwendung in einer elektrischen Maschine, insbesondere in einem Elektromotor, vorzugsweise einem Außenläufermotor, mit einem Platinenkörper (3), auf dem wenigstens eine elektrische/elektronische Komponente (1, 15, 20) vorgesehen ist und der wenigstens zwei gegeneinander bewegliche formstabile Segmente (4 bis 6, 17) aufweist, die durch wenigstens eine Biegestelle (7, 8, 18, 19) miteinander verbunden sind, wobei die elektrische/elektronische Komponente am Segment (4 bis 6, 17) vorgesehen ist und die Biegestelle (7, 8, 18, 19) durch eine Querschnittsverjüngung des Platinenkörpers (3) gebildet ist, wobei die elektrische/elektronische Komponente (1, 15, 20) elektrisch leitend mit wenigstens einem Anschluss (10) verbunden ist, der an einem der Segmente (4 bis 6, 17) vorgesehen ist,
**dadurch gekennzeichnet, dass** zumindest eines der Segmente (4 bis 6, 17) einen abstehenden Arm (12 bis 14) aufweist, an dem die elektrische/elektronische Komponente (1, 15, 20) vorgesehen ist, und dass benachbarte Arme (12 bis 14), die sich aus mit Armen versehenen Segmenten erstrecken, Abstand voneinander haben.

2. Platine nach Anspruch 1, **dadurch gekennzeichnet, dass** die elektrische/elektronische Komponente (1, 15, 20) ein SMD-Bauteil ist.

3. Platine nach Anspruch 1 oder 2, **dadurch gekennzeichnet, dass** die elektrische/ elektronische Komponente (1, 15, 20) ein Sensor ist.

4. Platine nach einem der Ansprüche 1 bis 3,
**dadurch gekennzeichnet, dass** die elektrische/elektronische Komponente (1) ein Lagegeber ist.

5. Platine nach einem der Ansprüche 1 bis 4,
**dadurch gekennzeichnet, dass** die elektrische/elektronische Komponente (15, 20) ein Temperatursensor ist.

6. Platine nach einem der Ansprüche 1 bis 5,
**dadurch gekennzeichnet, dass** der Anschluss (10) durch Kontaktstifte oder Kontaktflächen auf der Platine (2) gebildet ist.

7. Platine nach Anspruch 6,
**dadurch gekennzeichnet, dass** die Kontaktstifte (10) durch eine Leiste (11) gehalten sind.

8. Platine nach Anspruch 6 oder 7,
**dadurch gekennzeichnet, dass** die Leiste (11) und die elektrische/elektronische Komponente (1, 15) an der gleichen Seite des Platinenkörpers (3) vorgesehen sind.

9. Elektromotor mit einem Stator (23) und einem Rotor (24) und mit einer Platine (2) nach einem der Ansprüche 1 bis 8, die im Stator untergebracht ist und deren Segmente (4 bis 6) des Platinenkörpers (3) so gegeneinander geschwenkt sind, dass sie dem Durchmesser (9) der Magnete (28) des Rotors (24) angepasst sind.

10. Elektromotor nach Anspruch 9,
**dadurch gekennzeichnet, dass** die Platine (2) hochkant im Stator (23) angeordnet ist.

11. Elektromotor nach Anspruch 9 oder 10,
**dadurch gekennzeichnet, dass** die Biegestelle (7, 8) des Platinenkörpers (3) etwa parallel zur Achse des Stators (23) liegt.

12. Elektromotor nach einem der Ansprüche 9 bis 11,
**dadurch gekennzeichnet, dass** die Platine (2) in den Rotor (24) eintaucht.

## Claims

1. Printed circuit board (2) for use in an electric machine, particularly in an electric motor, preferably an outer rotor motor, having a printed circuit board body (3), on which at least one electric/electronic component (1, 15, 20) is provided and having at least two dimensionally stable segments (4 to 6, 17), which can be moved with respect to one another and are connected to one another by means of at least one bending point (7, 8, 18, 19), wherein the electric/electronic component is provided on the segment (4 to 6, 17) and the bending point (7, 8, 18, 19) is formed by means of a tapering of the cross section of the printed circuit board body (3), wherein the electric/electronic component (1, 15, 20) is electrically conductively connected to at least one connection (10), which is provided on one of the segments (4 to 6, 17),
**characterized in that** at least one of the segments (4 to 6, 17) has a projecting arm (12 to 14), on which the electric/electronic component (1, 15, 20) is provided, and **in that** adjacent arms (12 to 14), which extend out of segments provided with arms, are spaced from one another.

2. Printed circuit board according to Claim 1, **characterized in that** the electric/electronic component (1, 15, 20) is an SMD component.

3. Printed circuit board according to Claim 1 or 2, **characterized in that** the electric/electronic component (1, 15, 20) is a sensor.

4. Printed circuit board according to one of Claims 1 to 3, **characterized in that** the electric/electronic component (1) is a position encoder.

5. Printed circuit board according to one of Claims 1 to 4, **characterized in that** the electric/electronic component (15, 20) is a temperature sensor.

6. Printed circuit board according to one of Claims 1 to 5, **characterized in that** the connection (10) is formed by contact pins or contact surfaces on the printed circuit board (2).

7. Printed circuit board according to Claim 6, **characterized in that** the contact pins (10) are held by a strip (11).

8. Printed circuit board according to Claim 6 or 7, **characterized in that** the strip (11) and the electric/electronic component (1, 15) are provided on the same side of the printed circuit board body (3).

9. Electric motor having a stator (23) and a rotor (24) and having a printed circuit board (2) according to one of Claims 1 to 8, which is accommodated in the stator and its segments (4 to 6) of the printed circuit board body (3) are pivoted in such a manner with respect to one another that they are adapted to the diameter (9) of the magnets (28) of the rotor (24).

10. Electric motor according to Claim 9, **characterized in that** the printed circuit board (2) is arranged edgewise in the stator (23).

11. Electric motor according to Claim 9 or 10, **characterized in that** the bending point (7, 8) of the printed circuit board body (3) lies approximately parallel to the axis of the stator (23).

12. Electric motor according to one of Claims 9 to 11, **characterized in that** the printed circuit board (2) dips into the rotor (24).

## Revendications

1. Platine (2) destinée à être utilisée dans une machine électrique, en particulier dans un moteur électrique, de préférence un moteur à rotor externe, comportant un corps de platine (3) sur lequel au moins un composant électrique/ électronique (1, 15, 20) est prévu et au moins deux segments mutuellement mobiles ont des segments dimensionnellement stables (4 à 6, 17) qui sont reliés entre eux par au moins un point de flexion (7, 8, 18, 19), dans lequel le composant électrique/électronique est prévu sur le segment (4 à 6, 17) et le point de flexion (7, 8, 18, 19) est formé par une coupe transversale effilée du corps de platine de circuit imprimé (3), dans lequel le composant électrique/électronique (1, 15, 20) est connecté électriquement à au moins une connexion (10), qui est prévue sur l'un des segments (4 à 6, 17),
**caractérisée en ce qu'**au moins un des segments (4 à 6, 17) a un bras saillant (12 à 14) sur lequel le composant électrique/électronique (1, 15, 20) est prévu, et que les bras adjacents (12 à 14), qui s'étendent à partir de segments pourvus de bras, sont espacés l'un de l'autre.

2. Platine selon la revendication 1, **caractérisée en ce que** le composant électrique/électronique (1, 15, 20) est un composant SMD.

3. Platine selon la revendication 1 ou 2, **caractérisée en ce que** le composant électrique/électronique (1, 15, 20) est un capteur.

4. Platine selon une des revendications 1 à 3, **caractérisée en ce que** le composant électrique/ électronique (1) est un codeur de position.

5. Platine selon une des revendications 1 à 4, **caractérisée en ce que** le composant électrique/ électronique (15, 20) est un capteur de température.

6. Platine selon une des revendications 1 à 5, **caractérisée en ce que** la connexion (10) est formée par des broches de contact ou des surfaces de contact sur la platine (2).

7. Platine selon la revendication 6, **caractérisée en ce que** les broches de contact (10) sont maintenues par une barrette (11).

8. Platine selon la revendication 6 ou 7, **caractérisée en ce que** la barrette (11) et le composant électrique/électronique (1, 15) sont prévus du même côté du corps de platine (3).

9. Moteur électrique comportant un stator (23) et un rotor (24) et comportant un circuit imprimé (2) selon une des revendications 1 à 8, qui est renfermé dans le stator et dont les segments (4 à 6) du corps de platine (3) sont pivotés les uns contre les autres de manière à être adaptés au diamètre (9) des aimants (28) du rotor (24).

10. Moteur électrique selon la revendication 9, **caractérisé en ce que** la platine (2) est disposée de chant dans le stator (23).

11. Moteur électrique selon la revendication 9 ou 10, **caractérisé en ce que** le point de flexion (7, 8) du corps de platine (3) est approximativement parallèle à l'axe du stator (23).

12. Moteur électrique selon une des revendications 9 à 11, **caractérisé en ce que** la platine (2) plonge dans le rotor (24).
